# EUROPÄISCHE PATENTSCHRIFT

(11) **EP 1 309 872 B1**
(45) Veröffentlichungstag und Bekanntmachung des Hinweises auf die Patenterteilung: **26.10.2005**
(21) Anmeldenummer: 01962599.5
(22) Anmeldetag: 09.08.2001
(51) Int. Cl.: G01R 19/00

(54) **DISKRETE NIEDRIGSTSTROMMESSUNG**
DISCRETE LOWEST CURRENT MEASUREMENT
MESURE DISCRETE DE COURANT TRES FAIBLE

(30) Priorität: 16.08.2000 DE 10040629
(43) Veröffentlichungstag der Anmeldung: 14.05.2003
(73) Patentinhaber: Step Sensortechnik und Elektronik Pockau Gmbh, 09509 Pockau (DE); Rösel, Günter, 01239 Dresden (DE)
(72) Erfinder: RÖSEL, Günter, 01239 Dresden (DE); THIEME, Ingolf, 09496 Marienberg (DE); BALDAUF, Detlef, 09509 Pockau (DE)
(74) Vertreter: Adler, Peter
(86) Internationale Anmeldenummer: PCT/DE2001/002957
(87) Internationale Veröffentlichungsnummer: WO 2002/014878

(56) Entgegenhaltungen:
- DD-A- 119 940
- DE-A- 4 320 817
- DE-A- 4 320 818
- US-A- 5 572 118

## Beschreibung

Die Erfindung betrifft ein Verfahren zur diskreten Niedrigststrommessung bei dem in einem Meßzyklus Meßstrom einer Meß-Stromquelle in eine schaltbare Integratorkapazität nach einer bestimmten Meßzykluszeitdauer durch eine den Meßstrom repräsentierende Ausgangsspannung eines Integrator-Operationsverstärkers gemessen wird. In einem nachfolgendem Rücksetzzyklus wird eine Rücksetzintegration durchgeführt, indem ein von der Integrator-Kapazität fließender Rücksetzstrom durch einen Rücksetz-Halbleiterschalter geschaltet wird.

Die Erfindung betrifft weiterhin eine Schaltungsanordnung zur Durchführung des oben genannten Verfahrens.

Verfahren und Schaltungsanordnungen zur diskreten Niedrigststrommessung, also das diskontinuierliche Messen sehr kleiner Ströme, sind bisher nur bis zu einer Größenordnung von 10-14A bekannt. Wie in der DD 125170 beschrieben, sind hierbei Meßverfahren und ihre Realisierung in Schaltungsanordnungen bekannt, die in mindestens zwei Zyklen eingeteilt sind, wobei während eines Meßzyklusses ein Meßstrom eingangsseitig in einem Integrator integriert wird und die zugehörige Ausgangsspannung am Integratorausgang nach Ablauf einer bestimmten Meßzyklusdauer gemessen wird. Während eines sich daran anschließenden Rücksetzzyklus wird der Integrator mittels eines Rücksetz-Halbleiterschalters über einen Rücksetzstromwiderstand entladen, so daß sich ein nachfolgender Meßzyklus wieder anschließen kann, bei dem die gleichen Anfangsbedingungen für den Integrator vorliegen, wie bei dem vorherigen Meßzyklus.

Zum Messen von Strömen <10-14 A sind Langzeitmessungen mittels elektrometrischer Schaltungen z.B. bei Thermoluminiszensdosimeter üblich.

Eine andere Lösung für Niedrigstrommessung mit einem indirekten Messverfahren, welches über die indirekte Ausgangsgröße Frequenz den Messwert für den Niedrigstrom ermittelt, ist mit DE 43 20 817 A bekannt. Das hier eingesetzt Ladungsbalanceverfahren repräsentiert das Messprinzip der Differenzmessung, welches besonders klassisch mit dem Einsatz eines Differenziators nach DE 43 20 817 A realisiert ist.

In der technischen Realisierung sind die mit dem Ladungsbalanceverfahren vorzugsweise realisierten Spannungs/Frequenzumsetzer durch Merkmale einer ständig zugeschaltete Eingangsgröße (z.B. Aufintegration des nicht-geschalteten Eingangsstromes am Integrator) und eines jeweilig bestimmtes Rückintegrations-Quantum gekennzeichnet.

Hierbei wird der Aufintegration, die durch die ständige Beaufschlagung des Integrators durch das Mess-Eingangssignal verursacht wird, eine Rückintegration entgegengesetzt.

Eine Aussage bezüglich des Ausgleichs der Ladungsbilanz kann hierbei integrierend, also erst bei der Betrachtung des Messvorgangs über einen bestimmten Mindest-Zeitraum, erfolgen. Diese Aussage wird dann zu der vorliegenden Gesamt-Ladungsbilanz getroffen, wenn dieser Ausgleich mit der Ausführung einer Anzahl von abfolgenden Auf- und Rückintegrationen statistisch im Mittel so erreicht wird, also ausbalanciert ist, dass ein solch akzeptierter "Nullwert" bis auf einen für die angestrebte Genauigkeit vernachlässigbaren Restwert angenommen werden kann.

Gleichzeitig damit repräsentiert die Anzahl der Rückintegrationen, welche zu dieser Balance des Ladungsgleichgewichts in diesem Zeitraum führten, den Messwert.

In dieser speziellen Lösung wird ein am Integrator auftretender Fehlerstrom durch einen Kompensationsstrom, der ständig an dem Eingang der als Integrator arbeitenden Schaltung eingespeist wird, kompensiert.

Hierbei wird die Größe des Kompensationsstromes bei einem Abgleich der Schaltung auf niedrigste summarische Fehlerwirkung eingestellt, wobei die Ursache des Fehlerstroms und deren Verminderung damit nicht erreicht wird.

Eine weiteres Bespiel für eine Niedrigstrommessung mittels Ladungsbalanceverfahren ist mit DD 119 940 A bekannt.

Der Nachteil der bekannten Lösungen für Messungen von Strömen < 10-14 A besteht darin, daß mit dem über eine Vielzahl von Auf und Abintegrationen integrierenden Messverfahren ein Verfahren und Aufbau einer Schaltungsanordnung zur diskreten Niedrigststrommessung nicht realisierbar sind.

Der Erfindung liegt nunmehr die Aufgabe zugrunde, ein Verfahren und eine Schaltungsanordnung zum diskreten Messen von Strömen in der Größenordnung von 0,1 10-15 A unter Kompensation von Störgrößen wie Störladungseinflüsse von Halbleiterschaltern, Offsetspannung und -drift anzugeben.

Verfahrensseitig wird die Aufgabenstellung dadurch gelöst, daß eine durch eingekoppelte Störladungen verbundene Spannungsänderung am Ausgang des Integrator-Operationsverstärkers, welche durch eingekoppelte Störladungen beim Umschaltvorgang des Rücksetz-Halbleiterschalters zu Beginn und am Ende des Meßzyklusses hervorgerufen werden, mittels Hinzufügen eines in Phasenlage und Verstärkung geigneten Kompensationssignales zum Meßstrom der Meß-Stromquelle am Eingang des Integrator-Operationsverstärkers während des Meßzyklusses kompensiert wird.

Zum einen wird dadurch vor jeder Messung innerhalb eines Rücksetzzykluses nicht nur die mit dem Meßstrom geladene Integrator-Kapazität entladen, sondern während dieses Rücksetzzyklusses wird zusätzlich eine Koppel-Kapazität so geschaltet, daß diese auf die aktuelle Offsetspannung eines eingesetzten Integrator-Operationsverstärkers aufgeladen wird, und dadurch, wegen der invertierenden Operationsverstärkerschaltung, ein die Offsetspannung kompensierender Anfangsspannungswert am Integratorausgang in dem nachfolgenden Meßzyklus zur Verfügung steht. Da dieser Kompensationsvorgang vor jedem Meßzyklus ausgeführt wird, kann auch die Offsetspannungsdrift damit erfaßt und kompensiert werden. Die vor jeder Messung erforderliche Entladung der Integrator-Kapazität mit einem Rücksetz-Halbleiterschalter innerhalb eines Rücksetzzyklusses setzt voraus, daß dieser Rücksetz-Halbleiterschalter während der Integration des Meßstromes mit einer möglichst geringen Potentialdifferenz betrieben wird, um das Einspeisen unerwünschter Fehlerströme zu verringern, was schaltungstechnisch durch die Kompensation der Offsetspannung erreicht werden kann.

Zum anderen werden eingekoppelte Störladungen, welche durch Umschalten von Halbleiterschaltern, insbesondere beim Umschalten vom Meßzyklus zum Rücksetzzyklus und zurück, am Ausgang des Integrator-Operationsverstärkers eine Spannungsänderung verursachen, durch Einspeisung eines diesbezüglichen Kompensationssignales am Eingang des Integrator-Operationsverstärkers kompensiert.

Eine besonders vorteilhaften Variante des Verfahrens sieht vor, daß der Signalverlauf des Kompensationssignales durch genaue Abtastung verbunden mit kapazitiver Auskoppelung der dynamischen Spannungsänderung am Ausgang des Integrator-Operationsverstärkers in einer Kompensatorschaltung erzeugt wird und am Eingang dem Meßstrom in einer solchen Phasenlage und Amplitude hinzugefügt wird , sodaß die Wirkungen der Störladungen kompensiert werden. Es erfolgt somit die Erzeugung des hierfür erforderlichen Kompensationssignales dadurch, daß der dynamische Signalverlauf am Ausgang des Integrator-Operationsverstärkers kapazitiv ausgekoppelt wird und durch genaue Abtastung, in Phasenlage und Amplitude verstärkermäßig so weit geändert wird, daß durch nachfolgende kapazitiven Einkoppelung am Eingang des Integrator-Operationsverstärkers diese Störwirkung bis auf ein vernachlässigbaren Rest kompensiert wird.

Eine weitere vorteilhafte Variante des Verfahrens sieht vor, daß vor jeder Messung in einem Rücksetzzyklus, gleichzeitig der Integrationsstrom der vorherigen Messung über einen Rücksetzstrom-Widerstand durch einen nach Masse geschalteten Rücksetz-Halbleiterschalter abfließt, und außerdem eine hierbei am Ausgang des Integrator-Operationsverstärkers nach Masse geschalteten ersten Koppelkapazität soweit geladen wird, daß sie am Ende des Rücksetzzyklusses eine solche Spannung trägt, die die Offsetspannung des Integrator-Operationsverstärkers repräsentiert und nach Abschalten der Meßzyklusschaltstromquelle mit endlicher Ausschaltzeit alle Potentialdifferenzen am ersten FET-Schalttransistor näherungsweise Null sind.

Die anordnungsseitige Lösung der Aufgabenstellung sieht vor, daß eine Reihenschaltung bestehend aus einem ersten Koppel-Widerstand und einer ersten Koppel-Kapazität zwischen dem Rücksetz-Halbleiterschalter und der gemeinsamen Verbindung der in Reihe geschaltenen verstärkungsbestimmenden Widerstände, bestehend aus erstem Integrator-Widerstand und zweitem Integrator-Widerstand, geschaltet ist, daß von dieser gemeinsamen Verbindung eine zweite Koppelkapazität zum Ausgang des Integrators-Operationsverstärkers geschaltet ist, daß vom Ausgang des Integrator-Operationsverstärkers eine dritte Koppel-Kapazität an einen Eingang einer Kompensatorschaltung angeordnet ist, daß der Ausgang der Kompensatorschaltung mit einer zweiten Integrator-Kapazität und diese wiederum mit dem ersten Eingang des Integrator-Operationsverstärkers verbunden ist.

Weiterhin sieht die anordnungsseitige Lösung der Aufgabenstellung solch eine vorteilhafte Ausführung des Rücksetz-Halbleiterschalters vor, daß der Rücksetz-Halbleiterschalter aus einer Reihenschaltung eines ersten FET-Schalttransistor und eines zweiten FET-Schalttransistor sowie einem zugeordneten Schalt-Widerstand besteht, wobei einerseits der Drainanschluß des ersten FET-Schalttransistors mit dem Rücksetzstrom-Widerstand und anderseits dessen Sourceanschluß mit dem Drainanschluß des zweiten FET-Schalttransistors, dem ersten Koppelwiderstand und einem Anschluß des Schalt-Widerstandes verbunden ist, wobei letzterer mit seinem anderen Anschluß an das Gate des ersten FET-Schalttransistor geschaltet ist, daß der Sourceanschluß des zweiten FET-Schalttransistors mit Masse und sein Gateanschluß mit der ersten Meßzyklussignalquelle verbunden ist. Erfindungsgemäß wird ein Rücksetz-Halbleiterschalter eingesetzt, der aus einer Reihenschaltung aus erstem FET-Schalttransistor und einem zweiten FET-Schalttransistor besteht, wobei der zweite FET-Schalttransistor mit dem Sourceanschluss an Masse geschaltet ist, sowie mit dem Drainanschluß eine gemeinsame Verbindung mit dem Sourceanschluß vom ersten FET-Schalttransistor hat. Der Drainanschluß des ersten FET-Schalttransistors ist an den Rücksetzstromwiderstand geschaltet, welcher den Entladestrom des Integrators während des Rücksetzzyklusses prägt. Die erste Meßzyklusspannungsquelle, welche am Gate des zweiten FET-Schalttransistors anliegt, schaltet im Rücksetzzyklus mittels HIGH-Potential diesen zweiten FET-Schalttransistor durch. Von einer Meßzyklusschaltstromquelle mit endlicher Ausschaltzeit wird ein Schalt-Widerstand, welcher von der gemeinsamen Verbindung beider FET-Schalttransistoren nach dem Gate des ersten FET-Schalttransistor geschaltet ist, gespeist, dessen Spannungsabfall mit dem erfolgten Durchschalten des zweiten FET-Schalttransistors auch das Durchschalten des ersten FET-Schalttransistor bewirkt, so daß der Entladestrom des Integrators nach Masse fließen kann. Da zusätzlich an der gemeinsamen Verbindung der FET-Schalttransistoren ein erster Koppelwiderstand geschaltet ist, welcher in Reihe mit einer ersten Koppelkapazität angeordnet ist, liegt diese erste Koppelkapazität in diesem Zustand des Rücksetzzyklusses potentialmäßig an Masse. Weil die erste Koppelkapazität mit ihrem anderen Anschluss auch mit dem invertierendem Eingang eines Integrator-Operationsvertsärkersverbunden ist, kann sich die erste Koppelkapazität auf das Potential der Offsetspannung während des Rücksetzzyklus aufladen.

Eine weitere anordnungsseitige Lösung der Aufgabenstellung sieht die vorteilhafte Ausgestaltung der Kompensationsschaltung derart vor, daß die Kompensatorschaltung aus einer Teilschaltung angeordnet ist, bestehend aus einem Trenn-Operationsverstärkers, der über einen nichtinvertierenden Eingang, einen invertierenden Eingang und einen Ausgang verfügt, wobei dessen nichtinvertierender Eingang mit der dritten Koppel-Kapazität verbunden ist und dessen Ausgang an einen invertierenden Eingang eines Inverter-Operationsverstärkers verbunden ist, welcher weiterhin mit einem zweiten Eingang, dem nichtinvertierendem Eingang, und einem Ausgang ausgestattet ist, wobei der nichtinvertierende Eingang an Masse geschaltet ist, und der Ausgang des Inverter-Operationsverstärkers mit einem Gate eines Kompensator-FET verbunden ist, daß dessen Drainanschluss an die Betriebsspannungsquelle geschaltet ist und dessen Sourceanschluss, einerseits mit der zweiten Integrator-Kapazität verbunden ist, wobei diese wiederum mit ihrem zweiten Anschluss mit der ersten Integrator-Kapazität verbunden ist, daß anderseits der Sourceanschluss des Kompensator-FET mit einem Anschluss eines Kompensator-Widerstandes verbunden ist, wobei der andere Anschluss des Kompensator-Widerstandes einerseits mit einem Anschluss einer Kompensator-Kapazität, und anderseits mit einem Arbeits-Widerstand verbunden ist, daß die Kompensator-Kapazität mit dem anderen Anschluss nach Masse geschaltet ist, daß der andere Anschluss des Arbeits-Widerstandes an den Drainanschluss eines Kompensator-Schalttransistors geschaltet ist, wobei an das Gate des Kompensator-Schalttransistors die zweite Meßzyklussignalquelle geschaltet ist, und sein Sourceanschluss an Masse geschaltet ist.

Erfindungsgemäß wird damit eine Kompensatorschaltung realisiert. Sie besteht somit aus einer zweiten Koppel-Kapazität die parallel zu dem ersten Integrator-Widerstand geschaltet ist, und einer dritten Koppel-Kapazität die vom Ausgang des Integrator-Operationsverstärker zu einem nichtinvertierendem Eingang eines Trenn-Operationsverstärkers geschaltet ist, wobei der Ausgang des Trenn-Operationsverstärkers zum invertierenden Eingang eines Inverter-Operationsverstärkersgeschaltet ist. Sein nichtinvertierender Eingang liegt an Masse. Der Ausgang des Inverter-Operationsverstärkers ist mit dem Gate eines Kompensator-FET verbunden, wobei dessen Drainanschluß an die Betriebspannung angeschlossen ist und dessen Sourceanschluß mit einem Kompensator-Widerstand verbunden ist. Der Kompensator-Widerstand steht mit seinem anderen Anschluß mit einer Kompensator-Kapazität und gleichzeitig mit einem Arbeits-Widerstand in Verbindung, wobei der andere Anschluß der Kompensator-Kapazität an Masse liegt. Weiterhin ist der andere Anschluß des Arbeits-Widerstandes mit dem Drainanschluß eines Kompensator-Schalttransistors verbunden, dessen Sourceanschluß an Masse liegt und dessen Gate an die zweite Meßzyklussignalquelle angeschlossen ist. Eine zweite Integrator-Kapazität ist einerseits mit der gemeinsamen Verbindung von Kompensator-Widerstand und Sourceanschluß des Kompensator-FET und anderseits mit der ersten Integrator-Kapazität sowie dem nichtinvertierendem Eingang des Integrator-Operaionsverstärkers geschaltet.

Die Erfindung soll nachfolgend anhand eines Ausführungsbeispieles näher erläutert werden. In den zugehörigen Zeichnungen zeigt,
- Fig. 1: ein Blockschaltbild der erfindungsgemäßen Schaltungsanordnung

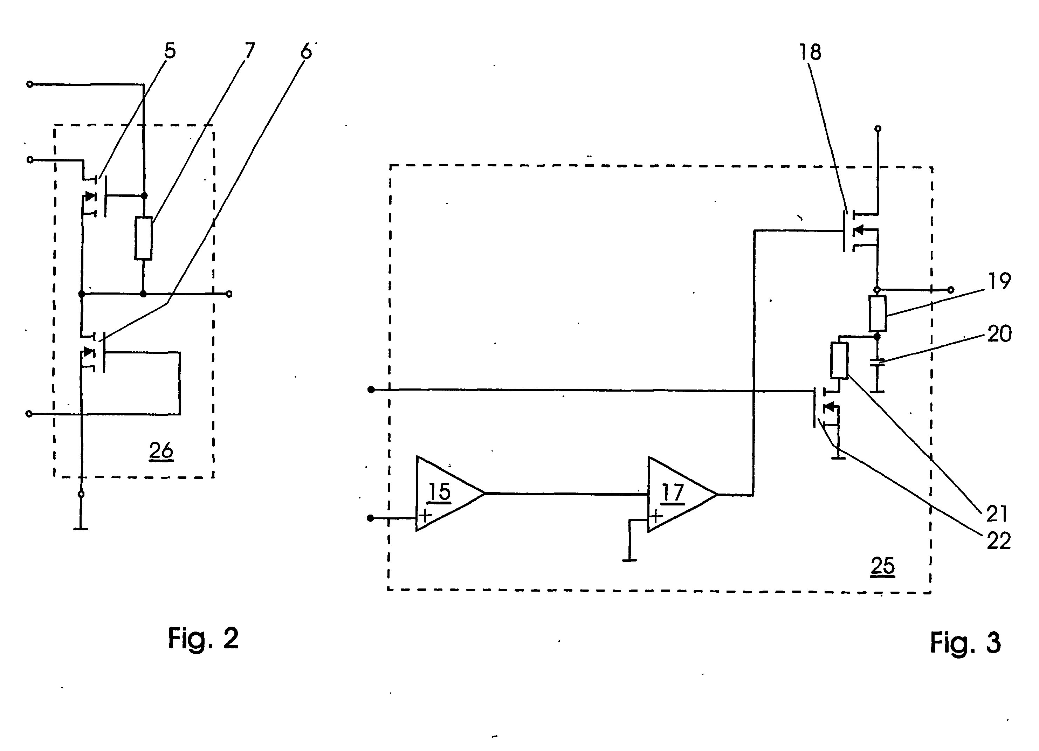

- Fig. 2: die erfindungsgemäße Schaltungsanordnung des Rücksetz-Halbleiterschalters
- Fig. 3: die erfindungsgemäße Schaltungsanordnung der Kompensationsschaltung

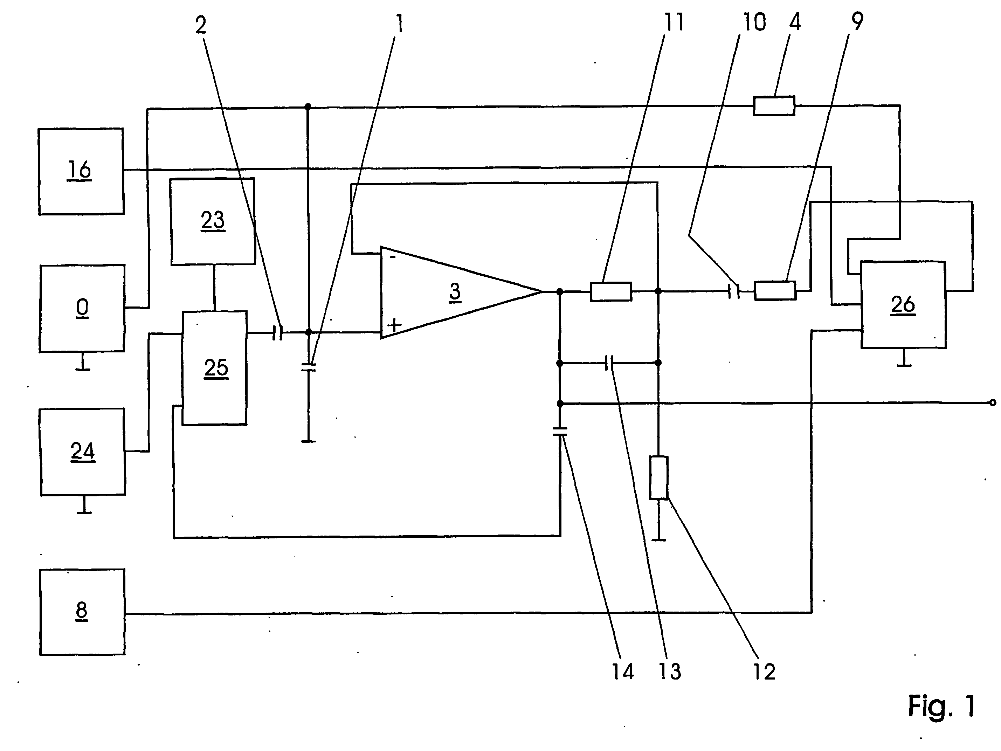

Wie in Fig. 1 ersichtlich, erfolgt die Integration des Meßstromes der Meßstromquelle 0 in der ersten Integrator-Kapazität 1 und die Integrationsspannung wird vom Integrator-Operationsverstärker 3 mit Hilfe des verstärkungsbestimmenden ersten Integrator-Widerstandes 11 und des zweiten Integrator-Widerstandes 12 als resultierende Ladespannung verstärkt und kann am Ende des Meßzyklusses als den Meßstrom repräsentierende Spannung am Ausgang des Integrator-Operationsverstärkers 3 gemessen werden. In dem sich anschließenden Rücksetzzyklus wird der Rücksetz-Halbleiterschalter 26 mittels der ersten Meßzyklussignalquelle 8 und der Meßzyklusschaltstromquelle mit endlicher Ausschaltzeit 16 durchgeschaltet, sodaß die erste Integrator-kapazität 1 nach Masse hin entladen wird. Gleichzeitig wird über den ersten Koppel-Widerstand 9 ein Anschluß der ersten Koppel-Kapazität 10 welcher in Reihe zum ersten Koppel-Widerstand 9 geschaltet ist, potentialmäßig auch an Masse gelegt, sodaß sie sich am Ende des Rücksetzzyklusses auf die aktuelle Offsetspannung des Integrator-Operationsverstärkers 3 aufladen kann und kompensiert die Offsetspannungswirkung des Integrator-Operationsverstärkers 3 im nachfolgenden Meßzykklus. Während der durch die Signalverläufe der Meßzyklusschaltstromquelle mit endlicher Ausschaltzeit 16 ausgelösten Umschaltvorgänge des Rücksetz-Halbleiterschalters 26 werden in den Übergängen vom Rücksetzzyklus zum Meßzyklus und umgekehrt in die erste Integrator-Kapazität 1 und zweite Integrator-Kapazität 2 Störladungen eingekoppelt. Diese werden in ihrer dynamischen Spannungswirkung am Ausgang des Integrator-Operationsverstärkers 3 über die zweite und dritte Koppel-Kapazitäten 13, 14 ausgekoppelt und am Eingang einer Kompensatorschaltung 25 bereitgestellt. Diese erzeugt ein Kompensationssignal, welches, gesteuert vom Signalverlauf der zweiten Meßzyklussignalquelle 24, über die zweite Integrator-Kapazität 2 eingekoppelt wird und die Störladungseffekte im darauf folgenden Meßzyklus kompensiert.

### Diskrete Niedrigststrommessung

### Bezugszeichenliste

- 0: Meß-Stromquelle
- 1: erste Integrator-Kapazität
- 2: zweite Integrator-Kapazität
- 3: Integrator-Operationsverstärker
- 4: Rücksetzstrom-Widerstand
- 5: erster FET-Schalttransistor
- 6: zweiter FET-Schalttransistor
- 7: Schalt-Widerstand
- 8: erste Meßzyklussignalquelle
- 9: erster Koppel-Widerstand
- 10: erste Koppel-Kapazität
- 11: erster Integrator-Widerstand
- 12: zweiter Integrator-Widerstand
- 13: zweite Koppel-Kapazität
- 14: dritte Koppel-Kapazität
- 15: Trenn-Operationsverstärker
- 16: Meßzyklusschaltstromquelle mit endlicher Ausschaltzeit
- 17: Inverter-Operationsvertsärker
- 18: Kompensator-FET
- 19: Kompensator-Widerstand
- 20: Kompensator-Kapazität
- 21: Arbeits-Widerstand
- 22: Kompensator-Schalttransistor
- 23: Betriebspannungsquelle
- 24: zweite Meßzyklussignalquelle
- 25: Kompensatorschaltung
- 26: Rücksetz-Halbleiterschalter

## Patentansprüche

1. Verfahren zur diskreten Niedrigststrommessung bei dem in einem Meßzyklus ein Meßstrom einer Meß-Stromquelle (0) in eine schaltbare Integrator-kapazität (1) nach einer bestimmten Meßzykluszeitdauer durch eine den Meßstrom repräsentierende Ausgangsspannung eines Integrator-Operationsverstärkers (3) gemessen wird und in einem nachfolgendem Rücksetzzyklus eine Rücksetzintegration durchgeführt wird, indem ein von der Integrator-Kapazität (1) fließender Rücksetzstrom durch einen Rücksetz-Halbleiterschalter (26) geschaltet wird **dadurch gekennzeichnet,**
**daß** eine durch eingekoppelte Störladungen verursachte Spannungsänderung am Ausgang des Integrator-Operationsverstärkers (3), welche durch eingekoppelte Störladungen beim Umschaltvorgang des Rücksetz-Halbleiterschalters (26) zu Beginn und am Ende des Meßzyklusses hervorgerufen wird, mittels Hinzufügen eines in Phasenlage und Verstärkung geeigneten Kompensationssignales zum Meßstrom der Meß-Stromquelle (0) am Eingang des Integrator-Operationsverstärkers (3) während des Meßzyklusses kompensiert wird.

2. Verfahren nach Anspruch 1 **dadurch gekennzeichnet, daß** der Signalverlauf des Kompensationssignales durch genaue Abtastung verbunden mit kapazitiver Auskoppelung der dynamischen Spannungsänderung am Ausgang des Integrator-Operationsverstärkers (3) in einer Kompensatorschaltung (25) erzeugt wird und am Eingang dem Meßstrom in einer solchen Phasenlage und Amplitude hinzugefügt wird , sodaß die Wirkungen der Störladungen kompensiert werden.

3. Verfahren nach Anspruch 1 **dadurch gekennzeichnet, daß** vor jeder Messung in einem Rücksetzzyklus, gleichzeitig der Integrationsstrom der vorherigen Messung über einen Rücksetzstrom-Widerstand (4) durch einen nach Masse geschalteten Rücksetz-Halbleiterschalter (26) abfließt, und außerdem eine hierbei am Ausgang des Integrator-Operationsverstärkers (3) nach Masse geschalteten ersten Koppelkapazität (10) soweit geladen wird, daß sie am Ende des Rücksetzzyklusses eine solche Spannung trägt, die die Offsetspannung des Integrator-Operationsverstärkers (3) repräsentiert und nach Abschalten der Meßzyklusschaltstromquelle mit endlicher Ausschaltzeit (16) und der zweiten Meßsignalquelle alle Potentialdifferenzen am ersten FET-Schalttransistor (5) näherungsweise Null sind.

4. Schaltungsanordnung zur diskreten Niedrigststrommessung mit einem Integrator-Operationsverstärkers (3), dessen erster Eingang mit einer Meß-Stromquelle (0) und mit einer ersten Integrator-Kapazität (1) verbunden ist, wobei letztere nach Masse geschaltet ist, sowie mit einem Rücksetzstrom-Widerstand (4) in Verbindung.steht, der wiederum mit einem Rücksetz-Halbleiterschalter (26) verbunden ist, wobei dieser an Masse und zusätzlich an eine erste Meßzyklussignalquelle (8) und die Meßzyklusschaltstromquelle mit endlicher Abschaltzeit (16) geschaltet ist, mit einer verstärkungsbestimmenden Reihenschaltung, bestehend aus erstem Integrator-Widerstand (11) und zweitem Integrator-Widerstand (12), die zwischen dem Ausgang des Integrator-Operationsverstärkers (3) und Masse geschaltet sind, wobei an ihrer gemeinsamen Verbindung der zweite Eingang des Integrator-Operationsverstärkers (3) geschaltet ist, **dadurch gekennzeichnet, daß** eine Reihenschaltung, bestehend aus einem ersten Koppel-Widerstand (9) und einer ersten Koppel-Kapazität (10), zwischen dem Rücksetz-Halbleiterschalter (26) und der gemeinsamen Verbindung der in Reihe geschaltenen verstärkungsbestimmenden Widerstände, bestehend aus erstem Integrator-Widerstand (11) und zweitem Integrator-Widerstand (12), geschaltet ist, daß von dieser gemeinsamen Verbindung eine zweite Koppelkapazität (13) zum Ausgang des Integrators-Operationsverstärkers (3) geschaltet ist, daß der Ausgang des Integrator-Operationsverstärkers (3) über eine dritte Koppel-Kapazität (14) mit einem Eingang einer Kompensatorschaltung (25) verbunden ist, und daß der Ausgang der Kompensatorschaltung (25) mit einer zweiten Integrator-Kapazität (2) und diese wiederum mit dem ersten Eingang des Integrator-Operationsverstärkers (3) verbunden ist.

5. Schaltungsanordnung nach Anspruch 4 **dadurch gekennzeichnet, daß** der Rücksetz-Halbleiterschalter (26) aus einer Reihenschaltung eines ersten FET-Schalttransistors (5) und eines zweiten FET-Schalttransistors (6) sowie eines zugeordneten Schalt-Widerstandes (7) besteht, wobei einerseits der Drainanschluß des ersten FET-Schalttransistors (5) mit dem Rücksetzstrom-Widerstand (4) und anderseits dessen Sourceanschluß mit dem Drainanschluß des zweiten FET-Schalttransistors (6), dem ersten Koppelwiderstand (9) und einem Anschluß des Schalt-Widerstand (7) verbunden ist, wobei letzterer mit seinem anderen Anschluß an das Gate des ersten FET-Schalttransistor (5) geschaltet ist, daß der Sourceanschluß des zweiten FET-Schalttransistors (6) mit Masse und sein Gateanschluß mit der ersten Meßzyklussignalquelle (8) verbunden ist, daß der Gateanschluß des ersten FET-Schalttransistors (5) mit der Meßzyklusschaltstromquelle mit endlicher Ausschaltzeit (16) verbunden ist.

6. Schaltungsanordnung nach Anspruch 4 und 5 **dadurch gekennzeichnet, daß** die Kompensatorschaltung (25) aus einer Teilschaltung angeordnet ist, bestehend aus einem Trenn-Operationsverstärkers (15), der über einen nichtinvertierenden Eingang, einen invertierenden Eingang und einen Ausgang verfügt, wobei dessen nichtinvertierender Eingang mit der dritten Koppel-Kapazität (14) verbunden ist und dessen Ausgang an einen invertierenden Eingang eines Inverter-Operationsverstärkers (17) verbunden ist, welcher weiterhin mit einem zweiten Eingang, dem nichtinvertierendem Eingang, und einem Ausgang ausgestattet ist, wobei der nichtinvertierende Eingang an Masse geschaltet ist, und der Ausgang des Inverter-Operationsverstärkers (17) mit einem Gate eines Kompensator-FET (18) verbunden ist, daß dessen Drainanschluss an die Betriebsspannungsquelle (23) geschaltet ist und dessen Sourceanschluss, einerseit mit der zweiten Integrator-Kapazität (2) verbunden ist, wobei diese wiederum mit ihrem zweiten Anschluss mit der ersten Integrator-Kapazität (1) verbunden ist, daß anderseits der Sourceanschluss des Kompensator-FET (18) mit einem Anschluss eines Kompensator-Widerstandes (19) verbunden ist, wobei der andere Anschluss des Kompensator-Widerstandes (19) einerseits mit einem Anschluss einer Kompensator-Kapazität (20), und anderseits mit einem ArbeitsWiderstand (21) verbunden ist, daß die Kompensator-Kapazität (20) mit dem anderen Anschluss nach Masse geschaltet, daß der andere Anschluss des Arbeits-Widerstandes (21) an den Drainanschluss eines Kompensator-Schalttransistors (22) geschaltet, wobei an das Gate des Kompensator-Schalttransistors (22) die zweite Meßzyklussignalquelle (24) geschaltet ist, und sein Sourceanschluss an Masse geschaltet ist.

## Claims

1. Method for the discrete measurement of very low currents, in which, in a measurement cycle, a current for measurement into a switchable integrating capacitor (1), coming from a source (0) of current for measurement, is measured, after a given measurement-cycle duration, by means of an output voltage from an integrating operational amplifier (3) which represents the current for measurement, and in a succeeding reset cycle a resetting integration is performed by switching a resetting current flowing from the integrating capacitor (1) through a resetting semiconductor switch (26), **characterised in that** a change in voltage at the output of the integrating operational amplifier (3) caused by coupled-in interference charges, which change in voltage is produced by coupled-in interference charges in the course of the changeover process of the resetting semiconductor switch (26) at the beginning and end of the measurement cycle, is compensated for by adding a compensating signal of suitable phase angle and amplification to the current for measurement from the source (0) of current for measurement, at the input of the integrating operational amplifier (3) during the measurement cycle.

2. Method according to claim 1, **characterised in that** the signal waveform of the compensating signal is generated in a compensating circuit (25) by exact sampling combined with capacitive decoupling of the dynamic change in voltage at the output of the integrating operational amplifier (3) and is added to the current for measurement at the input with a phase angle and an amplitude such that the effects of the interference charges are compensated for.

3. Method according to claim 1, **characterised in that**, before each measurement, the integrated current from the previous measurement flows away at the same time, in a reset cycle, via a reset-current resistor (4) and through a resetting semiconductor switch (26) which is connected to earth, and also, a first coupling capacitor (10) which is, in this case, connected to earth at the output of the integrating operational amplifier (3) is charged sufficiently for it to carry, at the end of the reset cycle, a voltage which represents the offset voltage of the integrating operational amplifier (3) and, after the switched measurement-cycle current source (16) having a finite switch-off time, and the second measurement-signal source, have switched off, all the differences in potential at the first FET switching transistor (5) are approximately zero.

4. Circuit arrangement for the discrete measurement of very low currents, having a integrating operational amplifier (3) whose first input is connected to a source (10) of current for measurement, to a first integrating capacitor (1), the latter being connected to earth, and to a reset-current resistor (4) which is connected in turn to a resetting semiconductor switch (26), the latter being connected to earth and also to a first measurement-cycle signal source (8) and to a switched measurement-cycle current source (16) having a finite switch-off time, and having a gain-determining series circuit comprising a first integrating resistor (11) and second integrating resistor (12) which are connected between the output of the integrating operational amplifier (3) and earth, the second input of the integrating operational amplifier (3) being connected to the point at which they are connected together, **characterised in that** a series circuit, comprising a first coupling resistor (9) and a first coupling capacitor (10), is connected between the resetting semiconductor switch (26) and the point at which the gain-determining resistors connected in series, comprising a first integrating resistor (11) and second integrating resistor (12), are connected together, **in that**, from this point of connection together, a second coupling capacitor (13) is connected to the output of the integrating operational amplifier (3), **in that** the output of the integrating operational amplifier (3) is connected via a third coupling capacitor (14) to an input of a compensating circuit (25), and **in that** the output of the compensating circuit (25) is connected to a second integrating capacitor (2) and the latter is connected in turn to a first input of the integrating operational amplifier (3).

5. Circuit arrangement according to claim 4, **characterised in that** the resetting semiconductor switch (26) comprises a first FET switching transistor (5), a second FET switching transistor (6) and an associated switching resistor (7), all connected in series, the drain terminal of the first FET switching transistor (5) on the one hand being connected to the reset-current resistor (4) and its source terminal on the other hand being connected to the drain terminal of the second FET switching transistor (6), to the first coupling resistor (9) and to one terminal of the switching resistor (7), the latter having its other terminal connected to the gate of the first FET switching transistor (5), **in that** the source terminal of the second FET switching transistor (6) is connected to earth and its gate terminal to the first measurement-cycle signal source (8), and **in that** the gate terminal of the first FET switching transistor (5) is connected to the switched measurement-cycle current source (16) having a finite switch-off time.

6. Circuit arrangement according to claims 4 and 5, **characterised in that** the compensating circuit (25) is arranged to be formed from a sub-circuit comprising an isolating operational amplifier (15) which has a non-inverting input, an inverting input and an output, its non-inverting input being connected to the third coupling capacitor (14) and its output being connected to an inverting input of an inverting operational amplifier (17) which is also fitted with a second input, i.e. the non-inverting input, and an output, the non-inverting input being connected to earth and the output of the inverting operational amplifier (17) being connected to a gate of a compensating FET (18), **in that** the drain terminal of the latter is connecting to the source of operating voltage (23) and its source terminal is connected on the one hand to the second integrating capacitor (2), the latter being connected in turn by its second terminal to the first integrating capacitor (1), **in that** the source terminal of the compensating FET (18) is connected on the other hand to one terminal of a compensating resistor (19), the other terminal of the compensating resistor (19) being connected on the one hand to one terminal of a compensating capacitor (20) and on the other hand to a load resistor (21), **in that** the compensating capacitor (20) is connected to earth by its other terminal, and **in that** the other terminal of the load resistor (21) is connected to the drain terminal of a compensating switching transistor (22), the gate of the compensating switching transistor (22) having the second measurement-cycle signal source (24) connected to it and its source terminal being connected to earth.

## Revendications

1. Procédé de mesure discrète d'un courant très faible, dans lequel un courant de mesure d'une source de courant de mesure (0) est mesuré, au cours d'un cycle de mesure, dans un condensateur-intégrateur commutable (1), suivant une durée définie du cycle de mesure, par une tension de sortie, représentant le courant de mesure, d'un amplificateur opérationnel-intégrateur (3) et dans lequel est réalisée, au cours d'un cycle de retour consécutif, une intégration de retour, tandis qu'un courant de retour, circulant depuis le condensateur-intégrateur (1), est commuté par un commutateur statique de retour (26),
**caractérisé en ce**
**qu'**une variation de tension, provoquée par des charges perturbatrices couplées à la sortie de l'amplificateur opérationnel-intégrateur (3), variation qui est suscitée par des charges perturbatrices couplées lors du processus de commutation du commutateur statique de retour (26) au début et à la fin du cycle de mesure, est compensée au moyen de l'ajout d'un signal de compensation approprié, en position de phase et en amplification, par rapport au courant de mesure de la source de courant de mesure (0), à l'entrée de l'amplificateur opérationnel-intégrateur (3), pendant le cycle de mesure.

2. Procédé selon la revendication 1, **caractérisé en ce que** l'allure du signal de compensation est produite par une exploration précise, liée à un découplage capacitif de la variation dynamique de tension à la sortie de l'amplificateur opérationnel-intégrateur (3), dans un circuit compensateur (25) et qu'il est ajouté à l'entrée au courant de mesure, en une position de phase et avec une amplitude, de telle sorte que les effets des charges perturbatrices sont compensés.

3. Procédé selon la revendication 1, **caractérisé en ce qu'**avant chaque mesure au cours d'un cycle de retour, le courant d'intégration de la mesure précédente s'évacue simultanément, par l'intermédiaire d'une résistance de courant de retour (4), par un commutateur statique de retour (26), relié à la masse et qu'un premier condensateur de couplage (10), relié à la masse, est chargé, en outre, ainsi, à la sortie de l'amplificateur opérationnel-intégrateur (3), dans la mesure où il supporte une telle tension à la fin du cycle de retour, tension qui représente la tension offset de l'amplificateur opérationnel-intégrateur (3) et que, après mise hors circuit de la source de courant de commutation du cycle de mesure avec un temps de coupure fini (16) et de la deuxième source du signal de mesure, toutes les différences de potentiel au premier transistor de commutation FET (5) sont approximativement égales à zéro.

4. Agencement de circuit pour une mesure discrète d'un courant très faible, avec un amplificateur opérationnel-intégrateur (3), dont la première entrée est reliée à une source de courant de mesure (0) et à un premier condensateur-intégrateur (1), ce dernier étant relié à la masse, de même qu'il est en liaison avec une résistance de courant de retour (4), qui est reliée à son tour à un commutateur statique de retour (26), celui-ci étant relié à la masse et, en plus, à une première source de signal du cycle de mesure (8) et la source du courant de commutation du cycle de mesure avec un temps de coupure fini (16), avec un couplage en série, définissant l'amplification, se composant d'une première résistance d'intégration (11) et d'une deuxième résistance d'intégration (12), qui sont reliées entre la sortie de l'amplificateur opérationnel-intégrateur (3) et la masse, la deuxième entrée de l'amplificateur opérationnel-intégrateur (3) étant relié à leur fonction commune, **caractérisé en ce qu'**un montage en série, se composant d'une première résistance de couplage (9) et d'un premier condensateur de couplage (10), est relié entre le commutateur statique de retour (26) et la fonction commune des résistances, définissant l'amplification, reliées en série, se composant de la première résistance d'intégration (11) et de la deuxième résistance d'intégration (12), qu'à partir de cette fonction commune, un deuxième condensateur de couplage (13) est relié à la sortie de l'amplificateur opérationnel-intégrateur (3), que la sortie de l'amplificateur opérationnel-intégrateur (3) est reliée, par l'intermédiaire d'un troisième condensateur de couplage (14), à une entrée d'un circuit compensateur (25) et que la sortie du circuit compensateur (25) est reliée à un deuxième condensateur-intégrateur (2) et que celui-ci est relié à son tour à la première entrée de l'amplificateur opérationnel-intégrateur (3).

5. Agencement de circuit selon la revendication 4, **caractérisé en ce que** le commutateur statique de retour (26) se compose d'un montage en série d'un premier transistor de commutation FET (5) et d'un deuxième transistor de commutation FET (6), ainsi que d'une résistance de commutation (7) associée, la borne de drain du premier transistor de commutation FET (5) étant reliée, d'une part, à la résistance du courant de retour (4) et sa borne de source étant reliée, d'autre part, la borne de drain du deuxième transistor de commutation FET (6), à la première résistance de liaison (9) et à une borne de la résistance de commutation (7), cette dernière étant reliée, par son autre borne, à la grille du premier transistor de commutation FET (5), que la borne de source du deuxième transistor de commutation FET (6) est reliée à la masse et que sa borne de grille est reliée à la première source de signal du cycle de mesure (8) et que la borne de grille du premier transistor de commutation FET(5) est reliée à la source du courant de commutation du cycle de mesure, avec un temps de coupure fini (16).

6. Agencement de circuit selon les revendications 4 et 5, **caractérisé en ce que** le circuit compensateur (25) est agencé à partir d'un circuit partiel, se composant d'un amplificateur opérationnel-séparateur (15), qui dispose d'une entrée non inverseuse, d'une entrée inverseuse et d'une sortie, son entrée non inverseuse étant reliée au troisième condensateur de couplage (14) et sa sortie étant reliée à une entrée inverseuse d'un amplificateur opérationnel-inverseur (17), lequel est équipé par ailleurs d'une deuxième entrée, l'entrée non inverseuse et d'une sortie, l'entrée non inverseuse étant reliée à la masse et la sortie de l'amplificateur opérationnel-inverseur (17) étant reliée à une grille d'un FET de compensation (18), **en ce que** sa borne de drain est reliée à la source de tension de service (23) et que sa borne de source est reliée d'une part, au deuxième condensateur-intégrateur (2), celle-ci étant reliée à son tour, par sa deuxième borne, au premier condensateur-intégrateur (1), que, d'autre part, la borne de source du FET de compensation (18) est reliée à une borne d'une résistance de compensation (19), l'autre borne de la résistance de compensation (19) étant reliée, d'une part, à une borne d'un condensateur de compensation (20) et, d'autre part, à une résistance de charge (21), que le condensateur de compensation (20) est relié à l'autre borne à la masse, que l'autre borne de la résistance de charge (21) est reliée à la fonction du drain d'un transistor de commutation de compensation (22), la deuxième source du signal du cycle de mesure (24) étant reliée à la grille du transistor de commutation de compensation (22) et que sa borne de source est reliée à la masse.
